# EUROPEAN PATENT APPLICATION

(11) **EP 4 672 882 A2**
(43) Date of publication of application: **31.12.2025**
(21) Application number: 25213750.0
(22) Date of filing: 05.11.2025
(51) Int. Cl.: H05K 7/14

(54) **POWER CONVERSION SYSTEM, ENERGY STORAGE SYSTEM, AND ELECTRIC DEVICE**

(30) Priority: 06.06.2025 CN 202510756308
(71) Applicant: Zhejiang Jinko Energy Storage Co., Ltd., Jiaxing, Zhejiang 314415 (CN)
(72) Inventor: CHENG, Min, Haining, 314415 (CN); LU, Yang, Haining, 314415 (CN); YU, Jian, Haining, 314415 (CN); XU, Guodong, Haining, 314415 (CN); ZHANG, Luhua, Haining, 314415 (CN); SUN, Xuebing, Haining, 314415 (CN)
(74) Representative: Haseltine Lake Kempner LLP

(57) **Abstract**

The present application relates to the field of energy storage system technologies, and in particular, to a power conversion system (PCS), an energy storage system, and an electric device. The PCS is applied to an energy storage system, and includes a cabinet. The cabinet is provided with an output compartment and a power conversion control compartment. The output compartment includes a plurality of output connection ports formed on a front panel of the cabinet. The power conversion control compartment includes a power board, a plurality of inductors, an AC output board, and a target printed circuit board (PCB). The target PCB is respectively connected to the power board, the plurality of inductors, and the AC output board.

## Description

### TECHNICAL FIELD

The present application relates to the field of energy storage technologies, and in particular, to a power conversion system (PCS), an energy storage system, and an electric device.

### BACKGROUND

A PCS utilizes a bidirectional DC/AC converter to achieve bidirectional conversion between battery DC power and grid AC power, and is configured to support switching between grid-connected and off-grid modes, thereby meeting various requirements such as grid frequency regulation, voltage regulation, and energy dispatch.

In the related art, due to a limitation on a size of an energy storage system and the fact that cells occupy most of the space in the energy storage system, the PCS consequently has a very small size. Moreover, a copper busbar in the PCS occupies a lot of space in the PCS, leading to difficulty in layout of other functional boards in the PCS.

### SUMMARY

Accordingly, a PCS, an energy storage system, and an electric device are provided.

In a first aspect, a PCS is provided, which is applied to an energy storage system. A cabinet of the PCS is provided with an output compartment and a power conversion control compartment. The output compartment includes a plurality of output connection ports disposed on a front panel of the cabinet. The power conversion control compartment includes a target PCB, and a power board, a plurality of inductors, and an AC output board that are respectively connected to the target PCB.

In some embodiments, the target PCB is located above the plurality of inductors and is electrically connected to all the plurality of inductors; and the AC output board is located above the target PCB and is electrically connected to the target PCB through a plurality of copper pillars.

In some embodiments, the output compartment includes an upper space and a lower space, the upper space of the output compartment including a plurality of high-voltage output devices, and the lower space of the output compartment being in communication with a lower space of the power conversion control compartment; a plurality of first ventilation holes are provided in the front panel of the cabinet at positions corresponding to the lower space of the output compartment; and a plurality of second ventilation holes are provided in a back panel of the cabinet at positions corresponding to the lower space of the power conversion control compartment; the plurality of first ventilation holes and the plurality of second ventilation holes being configured to dissipate heat from the lower space of the output compartment and the lower space of the power conversion control compartment; wherein the plurality of inductors are located inside the lower space of the power conversion control compartment.

In some embodiments, the lower space of the output compartment and the lower space of the power conversion control compartment in communication with each other form an external air duct, and a first cooling fan group is disposed in the lower space of the output compartment.

In some embodiments, a heat sink is further disposed in the lower space of the power conversion control compartment, and the power board is located above the heat sink and is electrically connected to the target PCB.

In some embodiments, the PCS further includes a plurality of current-sampling Hall sensors located on the AC output board, the power board being electrically connected to the plurality of current-sampling Hall sensors, and the current-sampling Hall sensors being electrically connected to a plurality of DC output terminals of the target PCB.

In some embodiments, the PCS further includes a control board, the control board being located in the power conversion control compartment; and the plurality of current-sampling Hall sensors are respectively electrically connected to the control board and transmit a plurality pieces of detected current data to the control board, and the control board is configured to protect the PCS according to the plurality pieces of current data.

In some embodiments, the control board is configured to perform the following steps: calculating, according to the current data detected by the current-sampling Hall sensors, a chopped wave power output by the power board; and determining, according to the chopped wave power output by the power board, whether an abnormality exists in an insulated-gate bipolar transistor (IGBT) group corresponding to the current-sampling Hall sensors.

In some embodiments, the target PCB includes a plurality of inductor connection points; the plurality of inductor connection points each being electrically connected to the corresponding inductor.

In some embodiments, the target PCB further includes a plurality of input connection points; the plurality of input connection points each being connected to an output connection point of the power board and each being further connected to the corresponding inductor connection point through a printed circuit on the target PCB.

In some embodiments, the target PCB further includes a plurality of output connection points; the plurality of output connection points each being connected to an input connection point of the AC output board and each being further connected to the corresponding inductor connection point through a printed circuit on the target PCB.

In some embodiments, the PCS further includes a second cooling fan group, the second cooling fan group being located on the back panel and at a position corresponding to an upper space of the power conversion control compartment; wherein a plurality of third ventilation holes are provided in the front panel and at positions corresponding to the upper space of the power conversion control compartment, and the plurality of third ventilation holes and the second cooling fan group are configured to form a cooling air duct in the upper space of the power conversion control compartment.

In some embodiments, in a second aspect, the present application provides an energy storage system, including a battery pack, a management sub-system, a thermal management system, and the PCS in any one of the foregoing embodiments.

In some embodiments, in a third aspect, the present application provides an electric device, including the PCS in any one of the foregoing embodiments.

### BRIEF DESCRIPTION OF THE DRAWINGS

In order to more clearly illustrate the technical solutions in embodiments of the present application, the accompanying drawings used in the description of the embodiments will be briefly introduced below. It is apparent that, the accompanying drawings in the following description are only some embodiments of the present application, and other drawings can be obtained by those of ordinary skill in the art from the provided drawings without creative efforts.
FIG. 1 is a schematic diagram of a PCS according to an embodiment of the present application.
FIG. 2 is a schematic diagram of an existing PCS according to an embodiment of the present application.
FIG. 3 is a schematic diagram of a target PCB according to an embodiment of the present application.

### Reference signs:

101: cabinet; 102: power board; 103: copper pillar; 104: AC output board; 105: second cooling fan group; 106: inductor; 107: target PCB; 108: IGBT group; 109: heat sink; 110: first cooling fan group; 201: copper busbar; 301: copper pillar connection point; 302: connecting copper wire; 303: inductor connection point.

### DETAILED DESCRIPTION

To facilitate understanding of the present application, a more comprehensive description of the present application will be given below with reference to the relevant accompanying drawings. Preferred embodiments of the present application are given in the drawings. However, the present application may be implemented in many different forms and is not limited to the embodiments described herein. Rather, these embodiments are provided to make the contents disclosed in the present application understood more thoroughly and comprehensively.

Unless defined otherwise, all technical and scientific terms used herein have the same meanings as would generally understood by those skilled in the technical field of the present application. The terms used herein in the specification of the present application are for the purpose of describing specific embodiments only, and are not intended to limit the present application. The term "and/or" used herein includes any and all combinations of one or more related listed items.

In a case that "include", "have", and "contain" described herein are used, unless explicit limitation terms such as "only" and "consist of ..." are used, another component may be further added. Unless otherwise mentioned, a term in a singular form may include a plural form, and cannot be understood as one in quantity.

It should be understood that, although terms such as "first" and "second" are used herein to describe various elements, these elements should not to be limited to these terms. The terms are merely used for distinguishing one element from another element. For example, without departing from the scope of the present application, a first element may be referred to as a second element, and similarly, a second element may be referred to as a first element.

In the present application, unless otherwise explicitly specified and limited, the terms "connected" and "connection" should be understood in a broad sense, for example, which may be a direct connection, an indirect connection through an intermediate medium, or communication inside two elements or an interaction relationship between two elements. Those of ordinary skill in the art can understand specific meanings of the foregoing terms in the present application according to a specific situation.

As a key component of an energy storage system, the PCS faces design challenges due to space constraints. The PCS achieves energy exchange between a battery and a grid through a bidirectional DC/AC conversion technology and has a seamless grid-connected/off-grid switching capability. Since the internal space of the energy storage system is mainly occupied by cells, a mounting space of the PCS is significantly compressed, resulting in a highly compact layout of internal elements thereof. Such spatial constraints impose higher requirements on heat dissipation design, maintenance accessibility, and reliability. Moreover, the arrangement of the copper busbar in the PCS occupies a lot of space in the PCS, leading to difficulty in layout of other functional boards in the PCS.

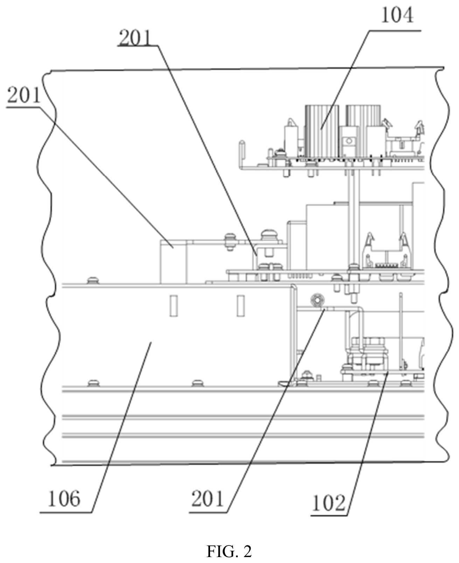

Referring to FIG. 2, FIG. 2, as a comparative embodiment of the present application, is a schematic diagram of a PCS.

In some embodiments, as shown in FIG. 2, in the PCS, an inductor 106 is connected to a power board 102 and an AC output board 104 through copper busbars 201. Since a shape and a connection position of the copper busbar 201 are required to correspond to positions of output connection points of the inductor 106, the copper busbar 201 occupies a lot of space. For example, the copper busbar 201, which connects the inductor 106 and the AC output board 104, occupies most of the space above the inductor 106. Consequently, other functional boards cannot be arranged in the space and can only be stacked above or below the AC output board 104, or occupy a position of an output compartment between the AC output board 104 and a front panel (not shown), resulting in excessively dense arrangement of a plurality of functional boards of the PCS. Moreover, due to the insufficient space in a power conversion control compartment and a larger number of functional boards required to be arranged in the power conversion control compartment, the functional boards in the power conversion control compartment may encroach on the the output compartment, which leads to interleaving of the output compartment and the power conversion control compartment, thereby causing a problem that high-voltage and low-voltage devices in the output compartment and the power conversion control compartment affect each other.

Still referring to FIG. 2, the inductor 106 and the power board 102 are also connected through the copper busbar 201. Since the shape and the connection position of the copper busbar 201 are required to correspond to positions of input connection points of the inductor 106 and the copper busbar 201 requires a certain routing path and assembly redundancy, the copper busbar 201 between the inductor 106 and the power board 102 occupies a height space and also occupies part of a length pace, leading to a requirement for an increase in a length of the cabinet 101 of the PCS or denser stacking of devices. However, the denser stacking of devices may further result in impossible effective heat dissipation of the devices. An additional cooling fan may significantly reduce ventilation efficiency due to blockage of the copper busbar 201.

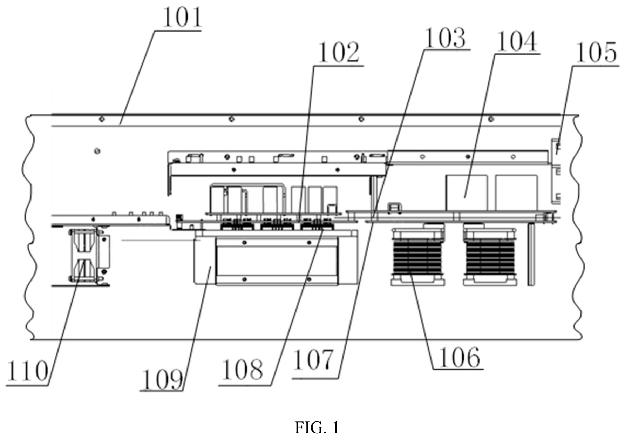

In some embodiments, the present application provides a PCS. Referring to FIG. 1 to FIG. 2, the PCS includes a cabinet 101. The cabinet 101 is provided with an output compartment and a power conversion control compartment.

The output compartment includes a plurality of output connection ports formed on a front panel of the cabinet 101. The power conversion control compartment includes a power board 102, a plurality of inductors 106, an AC output board 104, and a target PCB printed circuit board (PCB) 107. The target PCB 107 is respectively connected to the power board 102, the plurality of inductors 106, and the AC output board 104.

For example, the output compartment is a high-voltage compartment, and the power conversion control compartment is a low-voltage compartment. In this way, after the target PCB 107 is used instead of the copper busbars 201, the power board 102, the plurality of inductors 106, the AC output board 104, and the target PCB 107 may be stacked, which prevents extrusion of the space of the output compartment by the power conversion control compartment, thereby forming a separated layout design that the high-voltage and low-voltage compartments of the output compartment and the power conversion control compartment are separated.

For example, the output compartment may include a DC-side high-voltage component, an AC-side high-voltage component, a reactive power compensation board, a DC lightning protection and fuse protection board, a high-voltage switch and circuit breaker assembly, a power semiconductor device, and the like. The DC-side high-voltage component includes a DC busbar, a DC support capacitor, a DC filtering inductor, and the like. The DC busbar may be a low-resistance copper or aluminum bar, overlaid with a plurality of insulation layers such as epoxy resin coatings, and is configured to connect a battery cluster to the PCS, which can carry a DC voltage ranging from 1000 V to 1500 V. In a three-level topology, there is a need to achieve intermediate voltage balance control. The DC support capacitor may be a film capacitor that can improve a high ripple current withstand capability or an electrolytic capacitor suitable for low-cost solutions, which can suppress DC-side voltage fluctuations, absorb high-frequency harmonics, and provide transient current buffering during switching of an insulate-gate bipolar transistor (IGBT). The DC filtering inductor may be wound with an iron-silicon-aluminum core. An inductance value of the DC filtering inductor is adjusted according to a power requirement. The AC-side high-voltage component includes an inverter power unit, a step-up transformer, and the like. The inverter power unit may include a two-level, three-level, or multi-level topological structure. The step-up transformer may be a power-frequency transformer, a high-frequency transformer, or the like, which can boost a voltage of low-voltage AC power outputted from the PCS to match a grid connection requirement. The power semiconductor device may be an IGBT module, a metal-oxide-semiconductor field-effect transistor (MOSFET) module, or the like. The IGBT module may include an IGBT chip, a drive circuit, a heat dissipation substrate, and the like, which may employ a multi-level packaging structure. The MOSFET module has a withstand voltage level exceeding 1700 V and supports higher switching frequencies, which reduces losses by 30% compared to the IGBT, thereby being better suited for a high-frequency trend of the energy storage system. The reactive power compensation board is configured to dynamically adjust reactive power and optimize a grid-side power factor, and is suitable for high-voltage dynamic reactive power compensation and improvement in power transmission efficiency. The DC lightning protection and fuse protection board is configured to protect an internal circuit of the high-voltage compartment from damage caused by overvoltage or a short circuit. The high-voltage switch and circuit breaker assembly includes an AC circuit breaker such as a U/V/W phase circuit breaker, a DC isolation switch, and the like, to achieve on-off control and fault isolation of a high-voltage loop.

As an example, a plurality of insulation layers such as epoxy resin coatings are stacked, which can carry DC voltages such as 1000 V, 1300 V, and 1500 V.

Herein, it should be noted that the PCS proposed in the present application is applied to an energy storage system. The energy storage system is further provided with a battery pack, a battery management system for managing the battery pack, a fire protection system, and the like.

As an example, the battery pack is placed in a battery compartment of the energy storage system. A placement position and a quantity of the battery pack may be set according to an actual requirement. The battery pack may store power from the grid during off-peak hours and supply power to an external electric device during peak hours, to achieve peak shaving and valley filling for the power, thereby meeting seasonal regional power supply demands. The PCS is placed in a device compartment. The PCS is electrically connected to the battery pack and is configured to adjust an output voltage, a frequency, a phase number, and other electrical parameters when the battery pack outputs power externally, to ensure power supply from the battery pack to the external electric device. The battery management system is configured to manage the battery pack. Specifically, the battery management system may include an electrical cabinet. The electrical cabinet is placed in the device compartment. The electrical cabinet is electrically connected to the battery pack, to manage charging and discharging processes of the battery pack, such as monitoring charging and discharging voltages of the battery pack. The battery management system may further include a temperature sensor disposed on the battery pack and the like, to perform temperature monitoring on the battery pack, thereby ensuring safe and reliable operation of the battery pack. The fire protection system is configured to take corresponding fire suppression measures upon detecting a fire. It may be understood that a specific arrangement position of the fire protection system may be determined according to an actual requirement. In order to ensure safe operation of a micro energy storage system, the fire protection system may also be disposed in the battery compartment, or fire protection systems may be disposed in both the device compartment and the battery compartment.

As an example, the fire protection system may include apparatuses such as a temperature sensor, a smoke sensor, an automatic fire extinguisher, and a controller. The controller is connected to the temperature sensor, the smoke sensor, and the automatic fire extinguisher respectively, to be capable of determining, according to a temperature sensed by the temperature sensor and smoke sensed by the smoke sensor, whether a fire occurs, and when determining that a fire occurs, controls the automatic fire extinguisher to spray a fire extinguishing agent automatically, to achieve fire suppression. A partition between the battery compartment and the device compartment may be made of fire-resistant materials. When a fire occurs in the battery compartment or the device compartment, spread of the fire can be effectively blocked, and the fire is confined in the battery compartment or the device compartment, to effectively reduce device losses, lower a fire risk level, and gain valuable time for rescue.

Optionally, the energy storage system may further include a monitoring system. The monitoring system may include at least one of an audible and visual alarm, a gas discharge indicator, a ventilation mechanism, and a pressure relief mechanism. The audible and visual alarm may be disposed outside the energy storage system. The audible and visual alarm may, when an emergency such as a fire occurs in the energy storage system, issue a warning signal in the form of sound and/or light to alert staff for timely handling. The gas discharge indicator may be disposed outside the energy storage system. The battery pack may generate a certain amount of hydrogen during charging and discharging. When concentration of the hydrogen in the energy storage system reaches a certain level, the gas discharge indicator may issue a warning signal, such as sound and/or light, to alert the staff to perform a hydrogen venting operation on the energy storage system, thereby ensuring safety of the operation of the energy storage system. The ventilation mechanism may be configured to perform the hydrogen venting operation on the energy storage system. The ventilation mechanism may include an exhaust fan. When the hydrogen venting operation is required, the exhaust fan is activated manually or automatically.

Specifically, referring to FIG. 1, the target PCB 107 is located above the plurality of inductors 106 and is electrically connected to the plurality of inductors 106. The AC output board 104 is located above the target PCB 107 and is electrically connected to the target PCB 107 through a plurality of copper pillars 103.

Specifically, still referring to FIG. 1, the plurality of inductors 106, the target PCB 107, and the AC output board 104 are arranged in a stacked manner and are connected to one another through a plurality of copper pillars 103, Compared to the technical solution of connecting the plurality of inductors 106 and the AC output board 104 by using the copper busbar 201, a lot of space is saved.

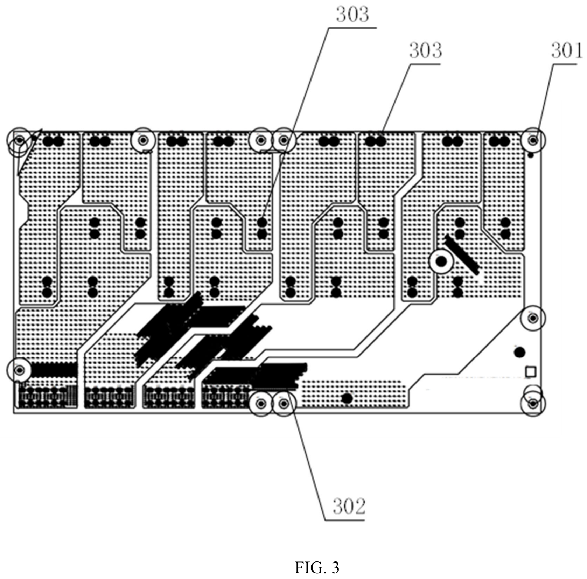

Referring to FIG. 3, the target PCB 107 includes a plurality of inductor connection points 303, a plurality of input connection points, and a plurality of output connection points. Positions of the plurality of inductor connection points 303 correspond to connection positions of the plurality of inductors 106. Each inductor connection point 303 is electrically connected to a wiring position of the corresponding inductor 106.

Each input connection point of the target PCB 107 is connected to an output connection point of the power board 102 through one copper pillar 103 and is further connected to the corresponding inductor connection point 303 through a printed circuit on the target PCB 107.

Each output connection point of the target PCB 107 is connected to an input connection point of the AC output board 104 through one copper pillar 103 and is further connected to the corresponding inductor connection point 303 through the printed circuit on the target PCB 107.

As an example, referring to FIG. 3, a plurality of inductor connection points 303 are formed on the target PCB 107, and each inductor connection point 303 is electrically connected to one input connection point and one output connection point corresponding to the corresponding inductor 106.

Still referring to FIG. 3, the target PCB 107 further includes a plurality of copper pillar connection points 301, and the copper pillar connection points 301 form electrical connections with the inductors 106 through a circuit layout on the target PCB 107, thereby enabling the target PCB 107 to achieve an effect of replacing the copper busbar 201.

Still referring to FIG. 3, a plurality of connecting copper wires 302 are further printed on the target PCB 107. Herein, on the target PCB 107, the connecting copper wires 302 are used to connect the inductors 106 to the copper pillars 103, which can meet requirements for high conductivity and stability of the PCS and can also prevent a heating risk caused by an electrical connection due to the use of another conductive material.

Still referring to FIG. 1 and FIG. 3, arrangement positions of the plurality of inductor connection points 303, the plurality of input connection points, and the plurality of output connection points of the target PCB 107 respectively correspond to positions of the plurality of inductors 106, the output connection points of the power board 102, and the input connection points of the AC output board 104, which ensures that the electrical connections among the AC output board 104, the target PCB 107, and the plurality of inductors 106 that are stacked are still formed through the medium of copper, eliminating a need to set a complex shape of the copper busbar 201, and only requiring the copper pillar 103 to complete the connections among the AC output board 104, the target PCB 107, and the plurality of inductors 106 that are stacked. The connection with the power board 102 through the copper pillar 103 ensures stability of the electrical connection and also reduces a volume of occupied space.

Specifically, the output compartment includes an upper space and a lower space.

Specifically, the upper space of the output compartment includes a plurality of high-voltage output devices.

Herein, it should be noted that, in the related art, since the copper busbar 201 occupies most of the space in the power conversion control compartment and the requirement for the size of the PCS, functional boards such as the power board 102 and the AC output board 104 are highly prone to encroaching on the output compartment. The mixed arrangement of the high-voltage and low-voltage compartments may significantly increase system complexity, leading to problems such as efficiency losses, increased failure rates, and safety risks, thereby causing substantial systemic hazards.

In some embodiments, the output compartment includes an upper space of the output compartment and a lower space of the output compartment, the upper space of the output compartment includes a plurality of high-voltage output devices, and the lower space of the output compartment is in communication with a lower space of the power conversion control compartment. A plurality of first ventilation holes are provided in the front panel of the cabinet 101 at positions corresponding to the lower space of the output compartment. A plurality of second ventilation holes are provided in a back panel of the cabinet 101 at positions corresponding to the lower space of the power conversion control compartment. The plurality of first ventilation holes and the plurality of second ventilation holes are configured to dissipate heat from the lower space of the output compartment and the lower space of the power conversion control compartment.

In some embodiments, the plurality of inductors are located inside the lower space of the power conversion control compartment.

Referring to FIG. 1, in some embodiments, the plurality of inductors 106 are located inside the lower space of the power conversion control compartment.

Specifically, the lower space of the output compartment and the lower space of the power conversion control compartment in communication with each other form an external air duct, and a first cooling fan group 110 is disposed in the lower space of the output compartment.

In this way, the target PCB 107 is used instead of the copper busbar 201, which prevents blockage of the cooling air by the copper busbar 201. The arrangement of the plurality of inductors 106 in the lower space of the power conversion control compartment enhances a heat dissipation capability for the plurality of inductors 106.

It should be noted that, in the PCS, the inductor 106 performs functions of current filtering and energy storage. However, when an alternating current passes through the inductor 106, copper loss, i.e., conductor resistance loss, and core loss, i.e., eddy current loss in a magnetic core occur, leading to a temperature rise in the device. If the inductor 106 cannot be effectively cooled, the losses of the inductor 106 may increase significantly, reducing overall power conversion efficiency of the PCS. Therefore, in the present application, the inductor 106 is disposed in the external air duct, ensuring heat dissipation efficiency for the inductor 106.

Specifically, still referring to FIG. 1, a heat sink 109 is further disposed in the lower space of the power conversion control compartment.

The power board 102 is located above the heat sink 109 and forms an electrical connection to the target PCB 107 through the copper pillar 103.

Herein, it should be noted that a plurality of power devices such as an IGBT and an MOSFET disposed on the power board 102 may generate a large amount of heat during power conversion. Therefore, in this embodiment, the power board 102 is disposed on the heat sink 109, the heat dissipation for the power board 102 is enhanced through the heat sink 109, and the heat sink 109 is disposed in the lower air duct to be in direct contact with the external cooling air, which ensures heat dissipation efficiency of the heat sink 109 and further improves the heat dissipation effect on the power board 102.

The heat sink 109 employs a fin structure to increase a heat dissipation area, and heat dissipation performance can be optimized by adjusting parameters such as fin heights, thicknesses, and widths. The first cooling fan group 110 can cooperate with the heat sink 109 to create forced convection, achieving balanced temperature distribution. The heat sink 109 may be made of a thermally conductive metal such as aluminum or copper, and a heat dissipation surface area can be increased through the fin structure.

Herein, since the copper busbar is not used in the PCS, in the embodiments of the present application, a lower air duct can be formed at the position of the plurality of inductors 106, and the lower air duct is in direct contact with external air, so that the cooling air flowing into the external air duct does not pass through other components, which ensures a cooling effect of the heat sink on a plurality of IGBT groups and also ensures a cooling effect of the heat sink 109 on the plurality of inductors 106.

The plurality of inductors 106 may be arranged in parallel or in a staggered manner. For the inductors 106 arranged in parallel, long axes of the inductors 106 should be parallel to a direction of a forced airflow, to reduce air flow resistance and increase a flow velocity. This design may allow the airflow to form laminar flow along a surface of the inductor 106, enhancing convective heat transfer efficiency. When finned inductors 106 are employed and arranged in parallel along an axial direction thereof, wind speed losses may be reduced by 15% to 20%. When staggered arrangement is employed for optimization, the plurality of inductors 106 are arranged in an array with a staggered layout at 45° to 60°, which enhances a turbulence effect by destroying an airflow boundary layer, and a heat transfer coefficient may be increased by 8% to 12%.

Optionally, a temperature detection apparatus may be disposed near the inductor, and the temperature detection apparatus and the first cooling fan group 110 are both connected to a control board. The control board can dynamically adjust a speed of the first cooling fan group 110 according to a real-time temperature of the inductor 106.

Specifically, referring to FIG. 1, the PCS further includes a second cooling fan group 105.

The second cooling fan group 105 is located on the back panel at a position corresponding to the upper space of the power conversion control compartment, a plurality of third ventilation holes are formed in the front panel at positions corresponding to the upper space of the power conversion control compartment, and the plurality of third ventilation holes are configured to form a cooling air duct in the upper space of the power conversion control compartment.

Herein, since the copper busbar is not used in the present application, the cooling air in the cooling air duct may not be blocked in the upper space. Due to a greater space for arranging the functional boards, gaps between the plurality of functional boards are also larger, which is more convenient for the circulation of the cooling air.

In this way, the target PCB 107 is used instead of the copper busbar 201, which prevents blockage of the cooling air by the copper busbar 201. Through the stacked design and the use of the copper pillar 103 to electrically connect the power board 102, the AC output board 104, and the target PCB 107, a certain spacing distance among the power board 102, the AC output board 104, and the target PCB 107 can be ensured when the power board 102, the AC output board 104, and the target PCB 107 are arranged in a stacked manner. In this way, the cooling air duct is formed in the upper space of the power conversion control compartment, which can effectively cool the power board 102, the AC output board 104, and the target PCB 107.

As an example, referring to FIG. 1, the PCS further includes a power supply board, an auxiliary power supply board, and the like. The power supply board is configured to supply power to the functional boards such as the control board and the power board 102. The auxiliary power supply board is configured to supply power to the first cooling fan group 110 and the second cooling fan group 105. Both the power supply board and the auxiliary power supply board are low-voltage boards and are disposed in the power conversion control compartment.

Specifically, still referring to FIG. 1, the PCS further includes a plurality of current-sampling Hall sensors (not shown).

The plurality of current-sampling Hall sensors are located on the AC output board 104, the power board 102 is connected to one end of the plurality of current-sampling Hall sensors through a plurality of copper pillars 103, and the Hall sensors are connected to a plurality of DC output terminals of the target PCB 107 through the copper pillars 103.

Specifically, still referring to FIG. 1, the PCS further includes a control board, and the control board is located in the power conversion control compartment.

The plurality of current-sampling Hall sensors are respectively electrically connected to the control board and transmit a plurality pieces of detected current data to the control board, and the control board is configured to protect the PCS according to the current data.

Herein, an output current of the power board 102 is detected by the Hall sensor, and data is transmitted in real time to the control board. When the current exceeds a threshold, the control board may immediately trigger a protection mechanism such as cutting off an IGBT drive signal, to prevent damage to the device due to overload. A Hall effect enables current sensing through a magnetic field, which eliminates a need for direct connection to a main circuit, thereby preventing additional losses and insulation risks caused by sampling resistors.

Further, still referring to FIG. 1, an output signal from the current-sampling Hall sensor is directly connected to the target PCB 107 through one copper pillar 103, thereby reducing long-distance noise transmission. In the related art, since the copper busbar 201 is required to form connections among the inductor 106, the power board 102, and the AC output board 104, shapes and routings thereof are fixed, and the cooling air from the plurality of functional boards has been blocked, it is very difficult to arrange an additional copper busbar 201 to detect the current data. In the related PCS, since the copper busbar 201 occupies most of the space, the control board is required to be disposed at a position in the output compartment far away from the power board 102 and is not directly connected to the AC output board 104.

In some embodiments, the control board is specifically configured to perform the following steps: for each current-sampling Hall sensor, calculating, according to the current data detected by the current-sampling Hall sensor, a chopped wave power output by the power board 102; and for each current-sampling Hall sensor, determining, according to the chopped wave power output by the power board 102, whether an abnormality exists in the IGBT group 108 corresponding to the current-sampling Hall sensor.

For example, still referring to FIG. 1, when the control board determines that an abnormality exists in a certain IGBT group 108, the control board may disconnect the abnormal IGBT group 108 from corresponding DC-side and AC-side power supplies. Generally, one IGBT group 108 corresponds to one battery pack, and after the abnormal IGBT group 108 is disconnected from the corresponding DC-side and AC-side power supplies, the energy storage system can still operate normally.

Optionally, the PCS further includes an inductor-capacitor (LC) filter module, and the LC filter module includes a plurality of filter capacitors and a plurality of filter inductors. The filter inductor and the filter capacitor may filter out double-frequency currents and ripple fluctuations from the battery. Furthermore, the filter inductor and the filter capacitor are devices with low failure rates and long lifespans, and are less prone to failure. However, the filter inductor has a relatively large mass, and a mounting spacing between the plurality of filter inductors cannot be excessively close.

In a possible implementation, the LC filter module has one side connected to an AC/DC power conversion module and the other side connected to a battery high-voltage box.

Optionally, the front panel of the cabinet 101 is provided with a PCS AC positive terminal, a PCS AC negative terminal, a low-voltage 15 V test terminal, a battery high-voltage box positive terminal, a battery high-voltage box negative terminal, a data transmission network port, a secondary control cable interface, a communication indicator, a bypass contactor on/off switch, an optical fiber communication interface, a high-voltage test terminal, and the like.

The PCS AC positive terminal and the PCS AC negative terminal are internally connected to positive and negative terminals of the bypass contactor respectively, and are externally connected in series with a PCS AC positive terminal and a PCS AC negative terminal of another high-voltage cascaded energy storage converter. The PCS AC positive terminal and the PCS AC negative terminal are configured to connect individual voltages of the AC/DC power conversion module in series, thereby enabling connection to a medium-high voltage. The low-voltage 15 V test terminal is connected to a power management controller (PMC) board, and before a high-voltage is applied to the device, the external device supplies power to the board, enabling observation and reading of a device state on the board. The PMC board is powered up under a low-voltage condition, to test and read operational performance of the module. The high-voltage test terminal is connected to an energy storage capacitor bank, and before the device is powered on, a DC energy storage capacitor bank may be powered up by an external voltage power supply, and the AC/DC power conversion module is powered on through the high voltage test terminal, to test performance of the module. The bypass contactor on/off switch serves as an operation interface of the bypass contactor, and is configured to implement a module self-bypass function and to automatically disconnect the bypass in case of a bypass fault, which requires manual resetting after module repair. The optical fiber communication interface belongs to an interface of the PMC board, and after being connected to an optical fiber, uploads a PMC signal to a control cabinet backend through an optical signal, or delivers a backend control instruction to the PMC board. Energy storage batteries on a battery cluster are connected in series and bused, and are finally connected to the battery high-voltage box positive terminal and the battery high-voltage box negative terminal. The data transmission network port may upload data monitored by the high-voltage box to the backend control cabinet through an RS-485 cable for remote control over the device. The battery high-voltage box is used to monitor parameters such as a voltage, a current, and a temperature of the energy storage system, and the information is transmitted to the control system. By monitoring the parameters, abnormal conditions in the system can be promptly found, and corresponding measures can be taken. The secondary control cable interface is connected to the energy storage battery. When an abnormal current or voltage occurs in the system, the circuit can be cut off in time to protect safety of the energy storage system and other electrical devices. The communication indicator is electrically connected to the battery high-voltage box and is configured to display device state information monitored by the battery high-voltage box and observe an operating state of the device. Generally, red indicates a fault, and green indicates normal operation.

Specifically, the cabinet 101 may include a structural frame, a front panel, a right-side panel, a left-side panel, a rear ventilation panel, a top cover panel, and the like. The structural frame may be formed by welding standard profiles and is configured to support internal devices, ensuring structural strength of the apparatus. The frame is designed with a lifting interface. The lifting interface includes a lifting mechanism. The frame, the front panel, the right-side panel, the left-side panel, the rear ventilation panel, the top cover panel, and the like are all made of metal materials, forming a protective enclosure of the device.

Referring to FIG. 1, in some embodiments, the control board further includes a signal transmission unit (not shown). The signal transmission unit may be connected to an alarming apparatus of the energy storage system in a wired or wireless manner. When the control board determines that an abnormality exists in a certain IGBT group 108, the signal transmission unit may be controlled to transmit an indication signal indicating that an abnormality exists in the IGBT group 108 to the alarming apparatus, to facilitate the staff to repair and replace the abnormal IGBT group 108.

In some embodiments, when an abnormality exists in a certain IGBT group 108, the control board may isolate the battery pack corresponding to the abnormal IGBT group 108 from a normal battery pack, and power of the abnormal battery pack may be transferred to the normal battery pack through the control board.

In the above PCS, the target PCB 107 is used instead of the copper busbar 201 for connection, which reduces space occupied by the connection through the copper busbar 201, and also facilitates a stacked design in the PCS, thereby ensuring separation of the high-voltage and low-voltage compartments and further reducing the size of the PCS through the stacked design.

The absence of the blockage of the copper busbar 201 facilitates the formation of the cooling air duct, which reduces the size of the PCS and also facilitates heat dissipation for the PCS.

In an exemplary embodiment, an energy storage system is provided, including a battery pack, a management sub-system, a thermal management system, and the PCS in any one of the foregoing embodiments.

In an exemplary embodiment, an electric device is provided. The electric device includes the PCS in any one of the foregoing embodiments.

Please note that the above embodiments are for illustrative purposes only and are not intended to limit the present application.

Various embodiments in the specification are described progressively. Each embodiment focuses on differences from other embodiments, and same and similar parts among the embodiments may be referred to one another.

## Claims

1. A power conversion system (PCS), applied to an energy storage system, and a cabinet (101) of the PCS being provided with an output compartment and a power conversion control compartment;
the output compartment comprising a plurality of output connection ports disposed on a front panel of the cabinet (101), and the power conversion control compartment comprising a target printed circuit board (PCB) (107), and a power board (102), a plurality of inductors (106), and an AC output board (104) that are respectively connected to the target PCB (107).

2. The PCS according to claim 1, wherein the target PCB (107) is located above the plurality of inductors (106) and is electrically connected to all the plurality of inductors (106); and
the AC output board (104) is located above the target PCB (107) and is electrically connected to the target PCB (107) through a plurality of copper pillars (103).

3. The PCS according to claim 1 or 2, wherein the output compartment comprises an upper space and a lower space, the upper space of the output compartment comprising a plurality of high-voltage output devices, and the lower space of the output compartment being in communication with a lower space of the power conversion control compartment; a plurality of first ventilation holes are provided in the front panel of the cabinet (101) at positions corresponding to the lower space of the output compartment; and a plurality of second ventilation holes are provided in a back panel of the cabinet (101) at positions corresponding to the lower space of the power conversion control compartment; the plurality of first ventilation holes and the plurality of second ventilation holes being configured to dissipate heat from the lower space of the output compartment and the lower space of the power conversion control compartment;
wherein the plurality of inductors (106) are located inside the lower space of the power conversion control compartment.

4. The PCS according to claim 3, wherein the lower space of the output compartment and the lower space of the power conversion control compartment in communication with each other form an external air duct, and a first cooling fan group (110) is disposed in the lower space of the output compartment.

5. The PCS according to claim 3, wherein a heat sink (109) is further disposed in the lower space of the power conversion control compartment, and the power board (102) is located above the heat sink (109) and is electrically connected to the target PCB (107).

6. The PCS according to any one of claims 1 to 5, further comprising a plurality of current-sampling Hall sensors located on the AC output board (104), the power board (102) being electrically connected to the plurality of current-sampling Hall sensors, and the current-sampling Hall sensors being electrically connected to a plurality of DC output terminals of the target PCB (107).

7. The PCS according to claim 6, wherein the PCS further comprises a control board, the control board being located in the power conversion control compartment; and
the plurality of current-sampling Hall sensors are respectively electrically connected to the control board and transmit a plurality pieces of detected current data to the control board, and the control board is configured to protect the PCS according to the plurality pieces of current data.

8. The PCS according to claim 7, wherein the control board is configured to perform the following steps:
calculating, according to the current data detected by the current-sampling Hall sensors, a chopped wave power output by the power board (102); and
determining, according to the chopped wave power output by the power board (102), whether an abnormality exists in an insulated-gate bipolar transistor (IGBT) group corresponding to the current-sampling Hall sensors.

9. The PCS according to any one of claims 1 to 8, wherein the target PCB (107) comprises a plurality of inductor connection points (303);
the plurality of inductor connection points (303) each being electrically connected to the corresponding inductor (106).

10. The PCS according to claim 9, wherein the target PCB (107) further comprises a plurality of input connection points; the plurality of input connection points each being connected to an output connection point of the power board (102) and each being further connected to the corresponding inductor connection point (303) through a printed circuit on the target PCB (107).

11. The PCS according to claim 9 or 10, wherein the target PCB (107) further comprises a plurality of output connection points; the plurality of output connection points each being connected to an input connection point of the AC output board (104) and each being further connected to the corresponding inductor connection point (303) through a printed circuit on the target PCB (107).

12. The PCS according to any one of claims 3 to 5, further comprising a second cooling fan group (105), the second cooling fan group (105) being located on the back panel and at a position corresponding to an upper space of the power conversion control compartment; wherein a plurality of third ventilation holes are provided in the front panel and at positions corresponding to the upper space of the power conversion control compartment, and the plurality of third ventilation holes and the second cooling fan group (105) are configured to form a cooling air duct in the upper space of the power conversion control compartment.

13. The PCS according to any one of claims 1 to 12, wherein the plurality of inductors (106) are arranged in parallel or in an array with a staggered layout at 45° to 60°.

14. An energy storage system, comprising:
a battery pack;
a management sub-system;
a thermal management system; and
the PCS according to any one of claims 1 to 13.

15. An electric device, comprising the PCS according to any one of claims 1 to 13.
